# EUROPEAN PATENT APPLICATION

(11) **EP 1 947 580 A1**
(43) Date of publication of application: **23.07.2008**
(21) Application number: 07001106.9
(22) Date of filing: 19.01.2007
(51) Int. Cl.: G06F 17/50, G06F 17/30

(54) **Method for displaying a CAD model**

(71) Applicant: :fepcon creative solutions GmbH, 71032 Böblingen (DE)
(72) Inventor: Häussermann, Markus, Dr.-Ing., 70569 Stuttgart (DE)
(74) Representative: Dreiss, Fuhlendorf, Steimle & Becker

(57) **Abstract**

To provide an increased aid during the development and optimisation of a product and to increase the explanatory power of a visualized CAD model (20) of the product it is suggested to automatically select at least one meta information (30) related to at least one component of the CAD model (20) from a product data management system (27) and automatically analyse the meta information (30). Depending on the result of the analysis, the graphical representation of the component is altered in order to indicate the meta information (30) or the result of the analysis of the meta information (30).

## Description

The invention relates to a system and a method for displaying a CAD model, wherein the CAD model describes at least one component of a product.

The invention also relates to a computer programme for displaying a CAD model.

Computer-aided design (CAD) assists design professionals, like engineers or architects, in their design activities. CAD denotes geometry authoring tools that are part of a socalled product lifecycle management (PLM) process and used to design, develop and optimize products, like machines, tools or buildings. CAD has become an important technology, because it causes lower product development costs and a shortened design cycle by enabling designers or engineers to develop a product on screen. CAD visualizes a two-dimensional and/or a three-dimensional model of a product and provides tools to manipulate the visualized product in a large variety of ways. Therefore, a CAD system provides a graphical user interface (GUI). A CAD model denotes CAD related data that primarily describe the shape of a product and are used for visualizing the product.

Shorter development times, increased product varieties and highly dynamic markets have an enormous influence on the product development process and caused the introduction of increased computer aided methods. This, in turn, lead to an increased amount of data and information that have to be handled in an appropriate way during the lifecycle of a product. Some of these data are organized in a CAD model and thus describe the design of a product, e.g. in terms of the shape and position of several components that are part of a product.

However, during the development and production of a product several further information are generated and/or needed. These information describe for example a schedule defining a time to market, possible suppliers for several components, regulations to be met by the product or some components, price lists, and so forth. These data are part of the product lifecycle management (PLM) and are stored within a product data management system (PDMS).

The information stored in the PDMS usually do not describe the shape or design of a product, since this is described via a CAD model. However, since data stored in the PDMS are related to the product or the components as describe in the CAD model, these data are from now on also denoted as meta information.

It is an object of the present invention to provide an increased aid during the development and optimization of a product. It is a further object of the invention to increase the explanatory power of a visualized CAD model of the product.

### Summary of the invention

The object is solved by a method for displaying a CAD model that comprises a step of automatically selecting meta information related to at least one component of the CAD model from a product data management system (PDMS) and automatically analysing the meta information. Depending on the result of the analysis, the graphical representation of the component is changed.

The inventive method thus enables to visualize meta information related to a product within the displayed CAD model. Generally, this could be achieved by changing a default graphical representation of the component depending on analysing at least one meta information retrieved from a product data management system (PDMS) and in order to highlight and thus visually represent the retrieved meta information or the result of the analysis of the meta information.

Preferably, at least one colour of at least one graphical element of the visualized component of the CAD model is manipulated. A graphical element could be the surface of an object, a boarder or an edge that is part of the component and that is displayed to an user of the system. According to this embodiment, the invention enables to display results of analysing meta information of a product or a component by changing the colour of the component or a least a part of the component while the component is viewed using a CAD system. This increases the facility of inspection of meta information that can be related to a CAD model of a product.

According to another preferred embodiment of the present invention, meta information of different kinds are stored in the PDMS and the kind of meta information to be retrieved can be selected. Usually, several different kinds of meta information are stored in a PDMS. However, a user often only is interested in a specific kind of meta information that should be visualized when viewing the CAD model. According to this embodiment, the user can predetermine the kinds of meta information that should be considered and visualized.

According to a further preferred embodiment of the present invention, at least one component of the CAD model is selected by a user and the meta information is retrieved depending on the selected component. Frequently, the CAD model comprises several components forming a product or at least a part of a product. However, a user often is only interested in meta information of one or more special components. This embodiment therefore enables the user to select the components according to which meta information should be retrieved and visualized.

Preferably, the manipulation of the graphical representation of the component in order to visualize analyzed meta information is performed according to predetermined criteria. These criteria describe e.g. graphical elements that should be affected and graphical means, like a colour or the thickness of a boarder line, that are used to visualize the analyzed meta information. It is conceivable that the GUI provides several menus that allow to specify such criteria, e.g. by defining attributes or by selecting one or more criteria out of a predefined list of criteria. The criteria could, for example, attach a specific colour to a possible result of the analysis. As another example, the criteria could define whether the whole component should be coloured or whether only specific borders or edges should be coloured. This makes the method and the system configurable according a user's needs and thus enables to further increase the facility of inspection.

According to a further preferred embodiment of the present invention, the retrieved meta information is categorized depending on predetermined criteria and the graphical representation of the component is manipulated to indicate the category of the retrieved meta information. A categorization could be performed, for example, to describe that a component is heavier than a predefined weight or to indicate that a component cannot be produced or delivered from a supplier within a predefined range of time. This information is then displayed within the CAD model by use of the inventive method.

For instance, the categorization could be performed in order to visualize all components that are supplied by a specific supplier. It is further conceivable that the categorization indicates whether components exist that could be used alternatively, or whether a component is manufactured according to a predefined manufacturing method. The categorization could also be used to indicate production related information, e.g. whether a component is self-produced, purchased from a supplier or whether the component has to meet a special standard or norm. The categorization could further indicate the status of the component, e.g. whether the component is a prototype, finally developed, or the like.

A categorization could further be performed to indicate a component's relation to a predefined functionality of the product, e.g. whether and how the predefined functionality is affected by the component. Further categories could define a release status or a kind of available meta information. Another category could define a process of generating a meta information, e.g. for describing who the meta information are generated. In case the meta information define a weight of the product, such a category could define whether the weight is determined by estimating, calculating or weighting the component.

Categories could also include current development status of the component, tasks that are still to be done, results of a quality inspection, results of packaging tests, current workflow status, availability of updated versions, relations to other projects or whether a component is on schedule.

Preferably, categories are configurable and allow to exactly visualize meta information retrieved from the PDMS that are currently needed by a user. Since frequently for each component a very large number of meta information is available, the concepts of analysing, determining the kind of meta information and building categories allow to filter the information retrieved from the PDMS in order to keep the visualized CAD model clear, which otherwise could reduce lucidity, since too much information might be visualized within the CAD model.

Preferably, the results of the analysis of the meta information are only visualized, if they match a combination of several criteria, e.g. if they belong to a combination of several categories. To define the criteria or the categories, the GUI could provide a text field enabling the user to enter a logical expression. The logical expression could then be evaluated by the system in order to define the filter criteria.

As an example, a logical expression could instruct the system to visualize components that are available, tested, supplied by a specific supplier, having a measured but not estimated weight, wherein the weight is measured and not just estimated.

According to another preferred embodiment of the present invention, a current state of development of the CAD model is defined e.g. in terms of meta information. Differences or commonalities are then visualized according to a previous version of the CAD model.

This embodiment enables to visualize the progress made in product development by comparing two versions of the product or of one or more components and visualizing the differences or the commonalities between the different versions in the visualized CAD model.

Preferably, differences or commonalities are also automatically visualized between the CAD model of the product and a CAD model of another product. This allows to clearly visualize differences between two products and may aid in deciding, which of two design alternatives to choose.

Preferably, the difference or the commonalities describe an added component, a deleted component, a changed meta information or a changed position of the component within the model. Differences and/or commonalities could also describe a material, a price, or a time of delivery of at least one component of the product.

According to another embodiment of the present invention, at least a part of the meta information or the result of the analysis of the meta information is visualized using a textual representation. The textual representation could be used additionally in order to display more details, whereas the graphical representation might be used to give an overview of one or several meta information or results of analysis.

Preferably, the textual representation is displayed using a table, a two-dimensional chart, a three-dimensional chart, or by automatically generating a report.

Advantageously, the components of the CAD model that should be considered are searched or selected within the visualized CAD model using a pointer device. This enables a way of selecting the components to be considered which is easy to handle.

According to another embodiment, the components of the CAD model are searched or selected based on a text string or via navigating through a text-based hierarchy. The text string could be a search string that is to be entered by a user e.g. using a keyboard. The text-based hierarchy could be formatted similar to commonly known directory structures.

The object is also solved by a system for displaying a CAD model, wherein the system provides means to execute the inventive method.

The realization of this invention in the form of a computer programme is particularly important. Parts of the computer programme may be run on different processing units to carry out the inventive method. The invention is, thereby, realized by the computer programme, wherein this computer programme represents the invention in the same sense as the method the computer programme is suitable to execute.

The computer programme is preferably stored in one or more storage elements. A storage element may in particular be a random access memory (RAM), a read only memory (ROM), an optical storage medium, a magnetic storage medium or a memory element attached to a processing unit.

Further features, applications and advantages of the invention will become apparent from the following description of exemplary embodiments of the invention that are shown in the drawings.

### Brief description of the drawings

- Figure 1: shows a schematized system for executing the inventive method according to a first embodiment;
- figure 2: exemplifies a graphical user interface; and
- figure 3: shows a simplified flow diagram according to another embodiment of the invention.

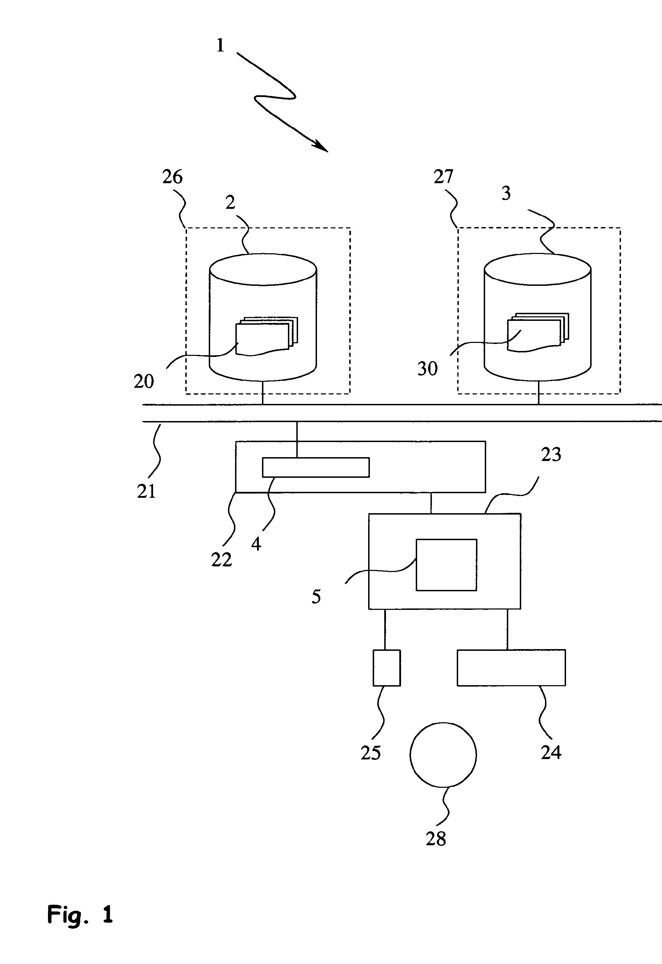

Figure 1 shows a system 1 comprising a first database 2, a second database 3, a functional unit 4 and a graphical user interface (GUI) 5. The database 2 comprises several CAD models 20 and the database 3 comprises meta information 30. The first database 2 can be attached to or part of a CAD system 26. The second database 3 can be attached to or part of a PDMS 27.

The CAD system 26 or at least the first database 2 is connected with the functional unit 4 via a communications system 21. The PDMS 27 or at least the second database 2 is also connected with the functional 4 unit via the communications system 21. The communications system 21 can be realised, for example, as a bus system or a communications network, e.g. the internet.

The functional unit 4 may be realised in software being executed on a computer system 22, e.g. a personal computer or a workstation. the functional unit 4 is adapted to request data models 20 from the CAD system 26 or at least from database 2, and to request meta information 30 from the PDMS 27 or at least from database 3. The functional unit 4 is further adapted to analyse the retrieved meta information 30 and to manipulate the presentation of the retrieved CAD model 20 in order to visualize the results of the analysis of the meta information 30.

The computer system 22 or at least the functional unit 4 allows interaction with an user 28 via the graphical user interface (GUI) 5, a pointer device 25 and a keyboard 24. The GUI 5 may be displayed on a monitor 23 attached to the computer system 22 in order to receive user input and to visualize the CAD model 20.

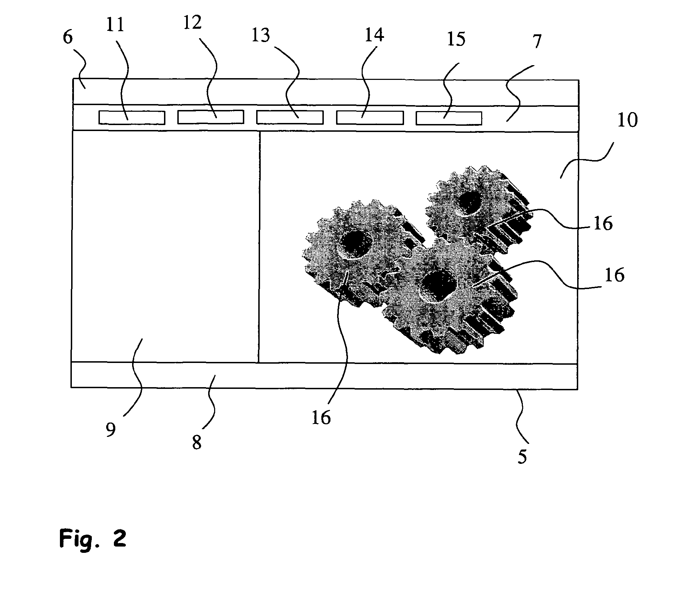

Figure 2 shows an exemplary GUI 5, comprising a title bar 6, a menu bar 7, a status bar 8, a text window 9 and a CAD window 10. The menu bar 7 comprises a menu button 11, enabling to display a menu for performing project related tasks, a display menu button 12 for activating a menu for performing display related tasks, an analysis menu button 13 enabling to display a menu for performing analysis related tasks, a menu button 14 enabling to display an options menu for configuring the system, and a menu button 15 enabling to display a help menu.

The text window 9 e.g. displays a hierarchical view of the product or at least the CAD model 20. In particular, text window 9 could display a list of parts and components of the product. Furthermore, the text window 9 may be enabled to display meta information related to the product and in particular to at least one selected component.

CAD window 10 displays components 16 that are part of the product. In particular, CAD window 10 allows to visualize meta information 30 related to the product or components 16 by changing a default graphical representation of the components 16, at least depending on the result of analysing the meta information 30.

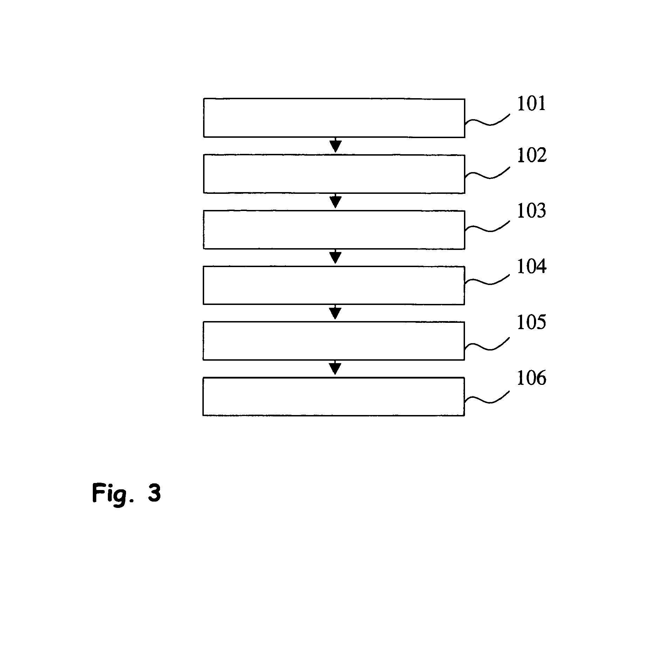

System 1 and GUI 5 are further described in the following description of a flow chart of the inventive method, as shown in figure 3. However, various further embodiments of the inventive system 1 are conceivable. E.g. database 2 and/or database 3 could also be realised as part of a directory system which could be accessed via a communications network or communications system 21. The CAD model 20 could then be derived from this directory system. Of course, various further concepts of data organisation could be applied in order to manage the data related to or realising the CAD models 20 and/or the meta information 30.

The method shown in figure 3 starts in a step 101, wherein the GUI 5 is displayed on the monitor 23 attached to the computer system 22. The GUI 5 could be designed as shown in figure 2. However, a wide variety of further designs and layouts are possible and able to provide the functionality needed to execute the inventive method.

It is further conceivable that the computer system 22 is realised as a server and that the GUI 5 is displayed via the monitor of a personal computer, the personal computer being connected through a communications network, e.g. communications system 21, with the server, wherein the functional unit 4 is executed on the server. The server could directly be connected to database 2 and database 3. Database 2 and database 3 could also be attached to further servers, reachable through a communications network. In particular, database 2 and database 3 could be realized in software or using one of various known concepts of data organization and executed on the same computer system 22 on which the functional unit 4 is executed and to which monitor 23 is attached.

In a step 102 the user 28 selects at least one kind of meta information 30 he is interested in. This could be performed by entering a text string that indicates the kind of meta information 30. It is further conceivable that the user 28 selects the kind of meta information 30 from a list that indicates the available kinds of meta information 30, wherein the list is displayed in the text window 9 or via a pull-down menu which is displayed upon activating a specific button, e.g. menu button 14.

The kinds of meta information 30 can directly correspond to the categories described above. The categories enable to define e.g. a threshold or a specific level according to meta information 30 that belong to a specific kind of meta information 30. For instance, a kind of meta information 30 could be the weight of a component 16. The meta information 30 itself then might describe the weight. A category could then be defined that allows to classify and thus distinguish components 16 that are heavier than a predefined threshold from components 16 that are lighter than the predefined threshold.

In step 102 the user 28 also selects one or more components 16 of a product that should be analysed based on the meta information 30 retrievable from database 3. The user could select a component 16 using the pointing device 25 which could be realised as a so called computer mouse. The pointing device 25 could be used to point and mark one or more components 16 currently shown in the CAD window 10. A component 16 could further be selected based on the textual hierarchical representation of the product and its components 16, as shown in the text window 9.

In a step 103 the relevant meta information 30 is retrieved from the PDMS 27 by the functional unit 4.

In a step 104 the retrieved meta information 30 is analysed according to several predetermined criteria. These criteria in particular comprise the selected component 16 and possibly selected categories. Generally, the analysis of the meta information 30 yields in generating information that is of interest to the user 28 and can be displayed within the CAD model.

In a step 105 the functional unit 4 determines, if and how the graphical representation of the component 16 has to be manipulated in order to visualize the results of the analysis together with the components 16 in the CAD window 10. Therefore, again several predefined parameters might be evaluated. These parameters might define the graphical element to be manipulated. In particular, the parameters might define the colour used to indicate the result of the analysis. This could be achieved by attaching a specific colour to each possible category of the meta information 30.

In a step 106 the components 16 are visualized in the CAD window 10 using the manipulated graphical representation and thus indicating the results of the analysis of the meta information 30.

The method could then be continued in step 102, if the user 28 changes the selections concerning the kind of meta information 30, component 16 or the category to be considered.

As indicated above, figure 3 shows an exemplified embodiment of the inventive method. Various further embodiments are conceivable. For example, in step 106 the meta information 30 could also be displayed using a textual representation.

It is further conceivable to omit step 103 and to preload meta information 30, e.g. when starting the program in step 101, instead. The CAD models 20 could also be preloaded. It is further conceivable that the meta information 30 and the CAD models 20 are loaded in a parallel process or in a background process.

Furthermore, the method could be configured according to various further parameters. These parameters could describe the behaviour of the GUI 5 in response to the analysed meta information 30. The parameters could also define further characteristics of the mapping of colours to categories, in order to visually indicate the category of a current analysis of the meta information 30. These parameters could also define further graphical elements and methods to be manipulated depending on the result of the analysis of the meta information 30.

The present invention enables to combine meta information 30 from a PDMS 27 with a CAD model 20 and to display information achieved by analysing the meta information 30 together with the CAD model 20. This allows to visualize information that is important to the user 28. The user 28 is free to configure the behaviour of the inventive method and the inventive system in order to select categories, meta information 30, kinds of meta information 30, graphical elements to be manipulated or mappings of colours to results of analysis.

The present invention allows for example to visually display all components 16 of a product that could not be developed or produced on schedule, e.g. by inking these components 16 with a red colour. The method could also be used to select several components 16 of a product and display these components 16 using a green colour, if these components are less in weight compared to a predefined requirement specification.

The inventive method might further be configured to display differences between a current development status and a previous development status of a product. This could be achieved by graphically highlighting components that were affected by changes. These changes could be induced by several meta information 30. Generally, each changed meta information 30 could be graphically visualized.

The inventive method could in particular be realised in software, i.e. in the form of a computer program. The computer program could be executed on the computer system 22. The computer program could further be distributed on various computers, e.g. servers and clients, wherein each of these computers is enabled to communicate with at least one further computer, preferably.

## Claims

1. Method for displaying a CAD model (20), the CAD model (20) describing at least one component (16) of a product and the method comprising steps of
- automatically retrieving meta information (30) related to at least one component (16) of the CAD model (20) from a product data management system;
- automatically analysing the retrieved meta information (30); and
- altering the graphical representation of the component (16) depending on the result of the analysis.

2. The method of claim 1, **characterized in that** the graphical representation is changed by manipulating at least one colour of at least one graphical element of the visualized component (16) of the CAD model (20).

3. The method of claim 1 or 2, **characterized in that** meta information (30) of different kinds are stored in the product data management system (27) and the kind of meta information (30) to be retrieved can be selected.

4. The method of anyone of the previous claims, **characterized in that** at least one component (16) of the CAD model (20) is selected by an user (28) and the meta information (30) is retrieved depending on the selected component (16).

5. The method of anyone of the previous claims, **characterized in that** the graphical representation of the component (16) is altered according to predetermined criteria.

6. The method of anyone of the previous claims, **characterized in that** the retrieved meta information (30) is categorized and the graphical representation of the component (16) is altered in order to indicate the category of the meta information (30).

7. The method of claim 6, **characterized in that** the categorisation is performed according to at least one of the following criteria:
- a supplier of the component (16),
- an existence of components (16) that can be used alternatively,
- a manufacturing method,
- a production related information of the component (16),
- a relation to predefined functionality,
- a release status,
- a kind of available meta information (30),
- a process of generating of at least one meta information (30),
- a current development status of the component (16),
- a kind of task to do,
- a result of a quality inspection,
- a result of a packaging test,
- a current workflow status,
- whether an updated version is available,
- at least one related project,
- whether a component (16) is on schedule.

8. The method of anyone of the previous claims, **characterized in that** the result of the analysis of the meta information (30) is only visualized if it matches a combination of several predefined criteria.

9. The method of anyone of the previous claims, **characterized in that** a status of development of the product is defined and differences or commonalities with another status of development of the product are automatically visualized.

10. The method of anyone of the previous claims, **characterized in that** a difference or a commonality to another product is determined in terms of meta information (30) and automatically visualized.

11. The method of claim 9 or 10, **characterized in that** the differences or commonalities describe at least one of
- an added component (16);
- a deleted component (16);
- a changed meta information (30);
- a changed position of the component (16) within the product or the CAD model (20).

12. The method of anyone of the previous claims, **characterized in that** at least a part of the meta information (30) or of the result of the analysis of the meta information (30) is visualized using a textual representation.

13. The method of anyone of the previous claims, **characterized in that** components (16) are searched or selected
- within the visualized CAD-model (20) using a pointer-device (25);
- based on a search string; or
- by navigating through a hierarchical view of the product or the CAD model (20).

14. System (1) for displaying a CAD model (20), **characterized in that** the system (1) provides means for executing a method according to at least one of claims 1 to 13

15. Computer program for displaying a CAD model (20), **characterized in that** the computer program is programmed to perform a method according to at least one of claims 1 to 13 if the computer program is executed on a computer system (22).

16. The computer program of claim 15, **characterized in that** the computer program is stored on a read only memory (ROM), a random access memory (RAM), an optical storage medium or a magnetic storage medium.
